# EUROPEAN PATENT SPECIFICATION

(11) **EP 4 689 683 B1**
(45) Date of publication and mention of the grant of the patent: **18.11.2026**
(21) Application number: 24716895.8
(22) Date of filing: 08.02.2024
(51) Int. Cl.: G01R 31/34

(54) **SYSTEM AND METHOD OF EXTRACTING MOTOR FAULT SIGNATURE USING SPARSITY-DRIVEN JOINT BLIND DECONVOLUTION AND DEMODULATION**
SYSTEM UND VERFAHREN ZUR EXTRAKTION VON MOTORFEHLERSIGNATUREN UNTER VERWENDUNG VON SPARSITY-GESTEUERTER GEMEINSAMER BLINDDEKONVOLUTION UND DEMODULATION
SYSTÈME ET PROCÉDÉ D'EXTRACTION DE SIGNATURE DE DÉFAUT DE MOTEUR À L'AIDE D'UNE DÉCONVOLUTION ET D'UNE DÉMODULATION AVEUGLE CONJOINTES DIRIGÉ PAR LA RARETÉ

(30) Priority: 27.03.2023 US 202318126586
(43) Date of publication of application: 11.02.2026
(73) Proprietor: Mitsubishi Electric Corporation, Chiyoda-ku Tokyo 100-8310 (JP)
(72) Inventor: LIU, Dehong, Cambridge, Massachusetts 02139-1955 (US); KELKAR, Varun, Cambridge, Massachusetts 02139-1955 (US)
(74) Representative: Pfenning, Meinig & Partner mbB
(86) International application number: PCT/JP2024/080012
(87) International publication number: WO 2024/204871

(56) References cited:
- LIU DEHONG ET AL: "Robust Motor Current Signature Analysis (MCSA)-based Fault Detection under Varying Operating Conditions", 2022 25TH INTERNATIONAL CONFERENCE ON ELECTRICAL MACHINES AND SYSTEMS (ICEMS), IEEE, 29 November 2022 (2022-11-29), pages 1 - 5, XP034253365, DOI: 10.1109/ICEMS56177.2022.9983454
- KIM HACK-EUN: "Machine prognostics based on health state probability estimation", THESIS QUEENSLAND UNIVERSITY OF TECHNOLOGY, 1 January 2010 (2010-01-01), pages 1 - 169, XP055888247, Retrieved from the Internet <URL:https://eprints.qut.edu.au/41739/1/Hack-Eun_Kim_Thesis.pdf> [retrieved on 20220207]
- KELKAR VARUN A ET AL: "Sparsity-Driven Joint Blind Deconvolution-Demodulation with Application to Motor Fault Detection", ICASSP 2023 - 2023 IEEE INTERNATIONAL CONFERENCE ON ACOUSTICS, SPEECH AND SIGNAL PROCESSING (ICASSP), IEEE, 4 June 2023 (2023-06-04), pages 1 - 5, XP034451234, DOI: 10.1109/ICASSP49357.2023.10094590

## Description

### [Technical Field]

The present invention is related to a system for extracting fault signatures of motors operating under varying speed or varying load conditions, based on motor current signature analysis.

### [Non-Patent Literature]

Non-Patent Literature 1: LIU OEHONG ET AL: "Robust Motor Current Signature Analysis (MCSA)-based Fault Oetection under Varying Operating Conditions", 2022 25TH INTERNATIONAL CONFERENCE ON ELECTRICAL MACHINES ANO SYSTEMS (ICEMS), IEEE, 29 November 2022 (2022-11-29), pages 1-5, XP034253365, 001: 10.1109/ICEMS56177 .2022.9983454
Non-Patent Literature 2: Kirn Hack-Eun: "Machine prognostics based on health state probability estimation", Thesis Queensland University of Technology, 1 January 2010 (2010-01-01), pages 1-169, XP055888247

### [Background Art]

Motor faults such as bearing fault, eccentricity fault, and broken-bar fault, etc., cause asymmetric rotating flux in the air gap between the stator and the rotor, and consequently induce extra frequency components in the stator current. Therefore, when there exists a motor fault, the frequency spectrum of the motor current includes not only the operating frequency component, but also the fault signature frequency component. Depending on the fault type, different faults exhibit different signatures. For instance, for eccentricity fault, the frequency components can be expressed as *fₛ* ± *mfᵣ,* where *fₛ* is the frequency of the power supply, *fᵣ* is a rotor frequency related to the rotational speed, and *m* = 0, 1, 2, ... .

Motor current signature analysis (MCSA), which aims to extract fault signatures in the frequency domain, has been widely used in motor fault detection. In the past decades, various MCSA-based methods have been developed to detection different types of faults in motors. MCSA-based methods work well in general for motors operating at steady status with a constant load and a constant rotating speed. However, when the motor under test is operating at varying conditions such as a fluctuating load, the motor current magnitude will vary adaptively to provide enough torque to drive the load. In such a situation, the fault signature, whose magnitude is generally much smaller than the operating frequency component, may be corrupted by the distorted frequency spectrum of the motor current due to varying operations or submerged by noise and other systematic perturbations. This issue becomes more evident when the fault is developing at its early stage. Therefore, it is desirable to develop advanced methods to recover the fault signature from varying motor current. Recent studies have considered specific models of load variations, such as phase modulation due to a sinusoidally varying load. For conditions when the load is varying with a specific pattern, time-frequency analysis methods may be used by analyzing multiple time-domain segments. However, time-frequency analysis methods suffer from an inherent tradeoff between time and frequency resolution. Recently, minimum variance (MV) beamforming-based denoising approach is introduced in this motor fault detection area to extract small fault signature under varying load conditions. MV beamforming-based denoising is good at removing random noise, but not capable of removing structured load fluctuations.
Non-Patent Literature 1 investigates how Motor Current Signature Analysis (MCSA) can be made robust under varying operating conditions such as changes in load, speed, and electrical supply. The authors develop an enhanced signal-processing and feature-stabilization method that keeps current-based diagnostic indicators reliable even when machine conditions fluctuate. Experimentally, the study shows that the improved approach enables more consistent and accurate fault detection, reducing sensitivity to noise and operational variability.
Non-Patent Literature 2 develops a probabilistic framework for machine prognostics, in which machine condition is expressed through health-state probability estimates derived from sensor-based degradation indicators. Technically, the work introduces methods for extracting health indicators, modeling their temporal evolution, and continuously updating probability distributions as new observations are obtained. The findings show that this probabilistic approach enables more accurate modeling of degradation progression and remaining useful life (RUL) compared to deterministic prediction methods.

Accordingly, there is a need to develop a novel method and a novel system, which are capable of extracting motor fault signatures while removing the structured load fluctuations. [Summary of Invention]

In this work, we propose a sparsity-driven method to extract fault signature from the time-domain stator current signal of a motor under varying load operations by solving a joint blind deconvolution and demodulation problem. The main contribution of our paper lies in the following three aspects. First, we build a physical model of the stator current, combining a modulation of the signal with an unknown load signal and a convolution with an unknown filter. Second, we cast the problem of recovering the steady-state stator signal with fault signatures as a joint deconvolution-demodulation optimization problem with proper assumptions. Third, we develop a proximal alternating linearized minimization-type method to solve the problem, assuming that the spectrum of the sought-after signal is sparse. We demonstrate the utility of our approach on signals collected from a real two-pole induction motor under varying load conditions.

Some embodiments of the present invention are based on recognition that a fault detection system is provided for detecting faults of an induction motor operating at varying operating conditions indicative of varying load conditions, varying speed conditions or combination thereof. The fault detection system includes a sensor device connected to a power cable of the induction motor, wherein the sensor device is configured to measure a stator current of the induction motor under the varying operating conditions via the power cable; a memory configured to store a computer-implemented fault detection method; a signal processor configured to perform steps of the computer-implemented fault detection method, wherein the steps comprise: forming a stator current vector by sampling the measured stator current using on a sampling frequency according to time sequences; reducing noise of the stator current vector using a minimum-variance (MV) beam forming method; formulating a joint blind deconvolution-demodulation optimization problem based on the stator current vector of a steady operating condition, a response vector of the induction motor, a modulation vector of varying operating conditions, and a noise vector to satisfy the measured stator current vector with reduced noise; estimating the stator current vector of the steady operating condition, the response vector of the induction motor, the modulation vector of the varying operating conditions, and the noise vector by solving the joint blind deconvolution-demodulation optimization problem; extracting fault signatures from a clean stator current estimate vector, wherein the clean stator current estimate vector is generated by use of the estimated response vector and the estimated stator current vector; producing a control command to a controller of the induction motor if at least one of the fault signatures is greater than a threshold and controlling the induction motor by transmitting the control command that causes the controller to reduce an operation speed of the induction motor to a safety level, otherwise producing and transmitting a normal command indicative of the normal operations of the induction motor to the controller.

According to some embodiments of the present invention, a computer-implemented method is provided for detecting faults of an induction motor operating at varying operating conditions indicative of varying load conditions, varying speed conditions or combination thereof. The method includes measuring a stator current of the induction motor under the varying operating conditions via a current sensor connected to a power cable of the induction motor; forming a stator current vector by sampling the measured stator current using on a sampling frequency according to time sequences; reducing noise of the stator current vector using a minimum-variance (MV) beam forming method; formulating a joint blind deconvolution-demodulation optimization problem based on the stator current vector of a steady operating condition, a response vector of the induction motor, a modulation vector of varying operating conditions, and a noise vector to satisfy the measured stator current vector with reduced noise; estimating the stator current vector of the steady operating condition, the response vector of the induction motor, the modulation vector of the varying operating conditions, and the noise vector by solving the joint blind deconvolution-demodulation optimization problem; extracting fault signatures from a clean stator current estimate vector, wherein the clean stator current estimate vector is generated by use of the estimated response vector and the estimated stator current vector; producing a control command to a controller of the induction motor if at least one of the fault signatures is greater than a threshold and controlling the induction motor by transmitting the control command that causes the controller to reduce an operation speed of the induction motor to a safety level, otherwise producing and transmitting a normal command indicative of the normal operations of the induction motor to the controller.

The accompanying drawings, which are included to provide a further understanding of the invention, illustrate embodiments of the invention and together with the description serve to explain the principle of the invention. The drawings shown are not necessarily to scale, with emphasis instead generally being placed upon illustrating the principles of the presently disclosed embodiments.

### [Brief Description of Drawings]

[Fig. 1A]

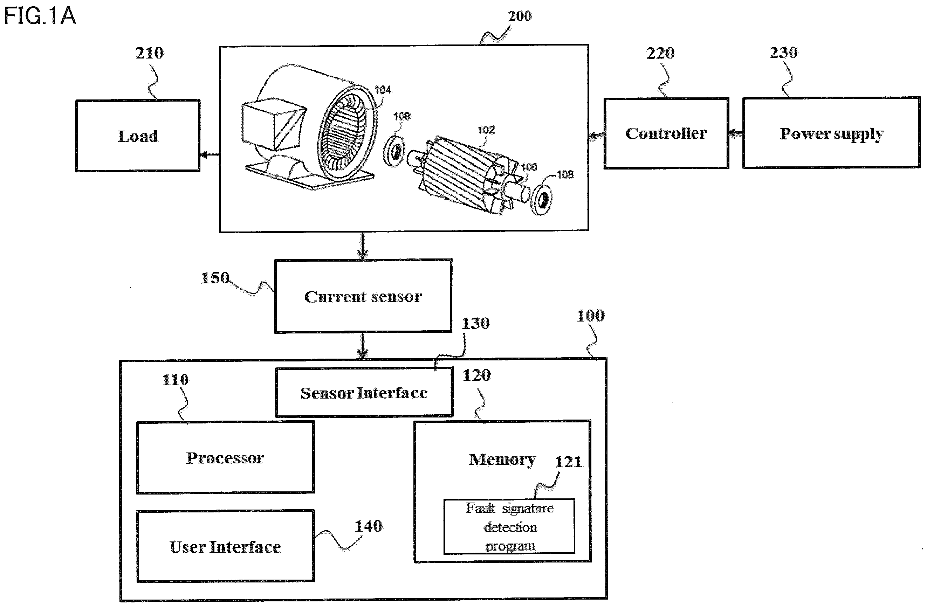

   Figure 1A is a schematic of a system for onsite operating and monitoring an induction motor according to one embodiment of an invention.
[Fig. 1B]

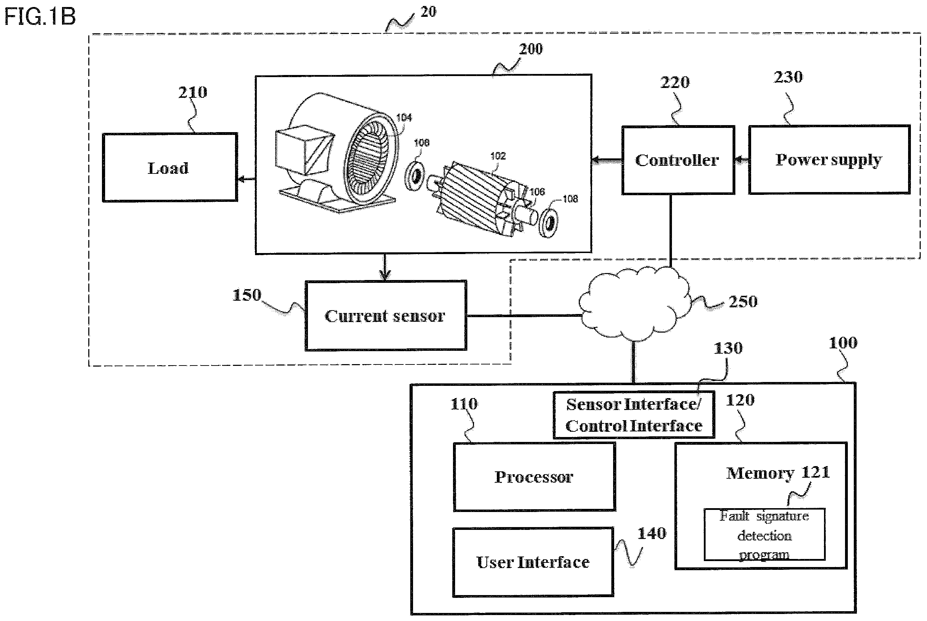

   Figure 1B is a schematic of a system for online (over-the-cloud) operating and monitoring an induction motor according to one embodiment of an invention.
[Fig. 2]

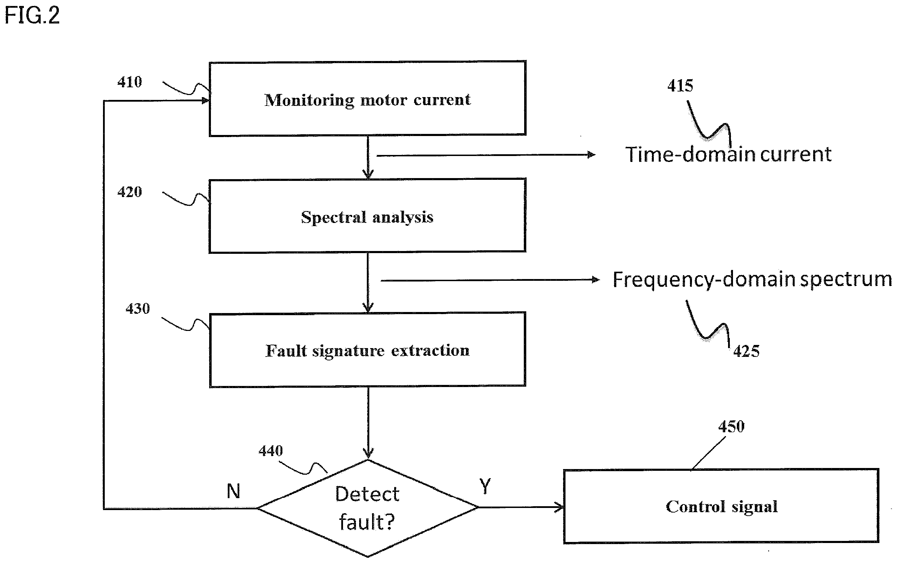

   Figure 2 is a block diagram of the fault detection process for an induction machine operating at varying operating conditions, according to embodiments of the present invention.
[Fig. 3]

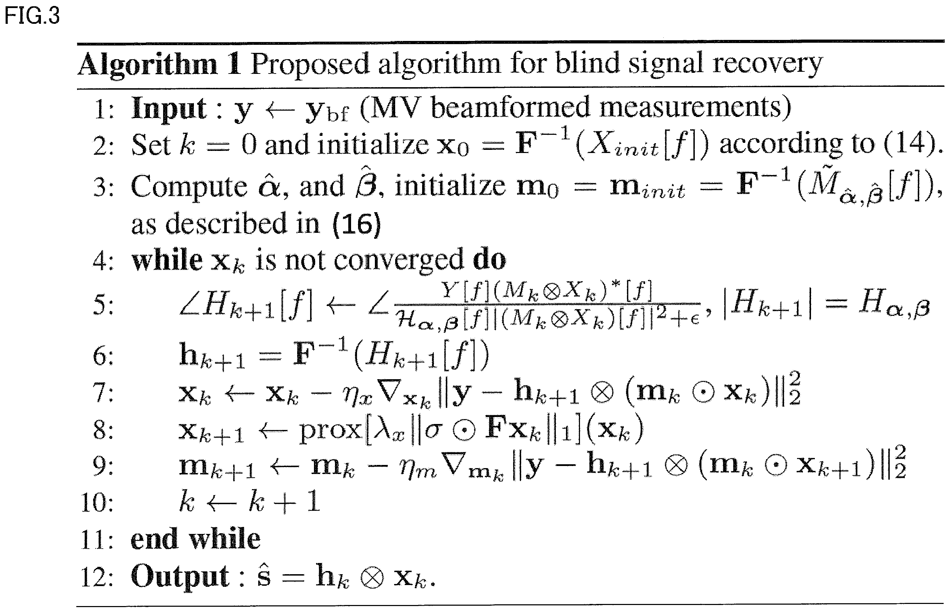

   Figure 3 is a detailed description of the spectrum analysis of stator current measured from an induction machine operating at varying conditions using a blind deconvolution-decomposition method, according to embodiments of the present invention.
[Fig. 4]

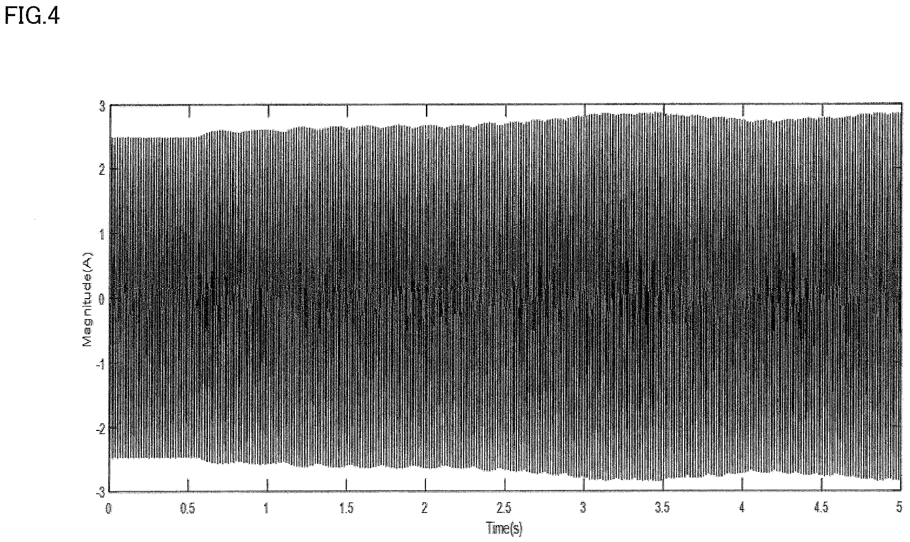

   Figure 4 is an exemplar plot of stator current in the time-domain of an induction machine operating at varying operating conditions according to embodiments of the present invention.
[Fig. 5]

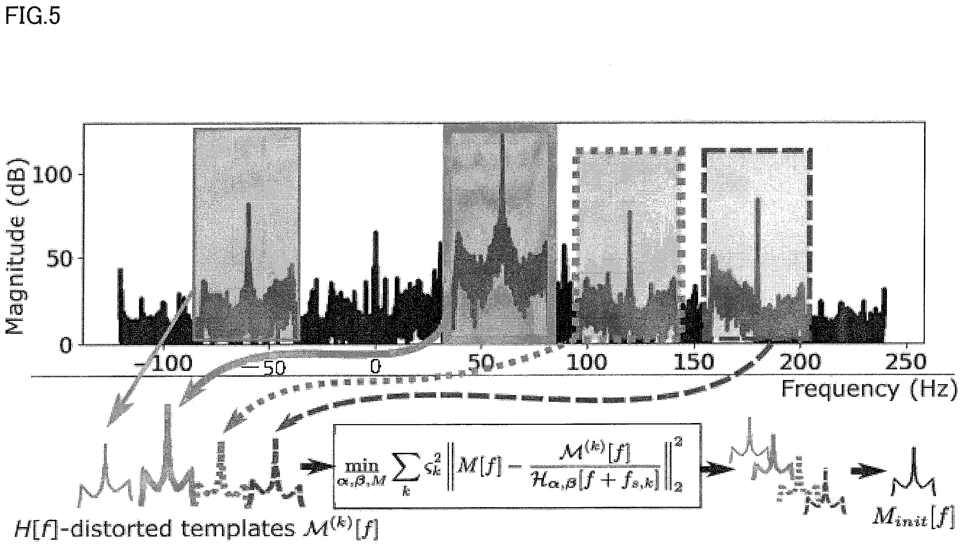

   Figure 5 is a schematic diagram of estimating the induction machine system response vector of the motor system and the modulation vector, according to embodiments of the present invention.
[Fig. 6A]

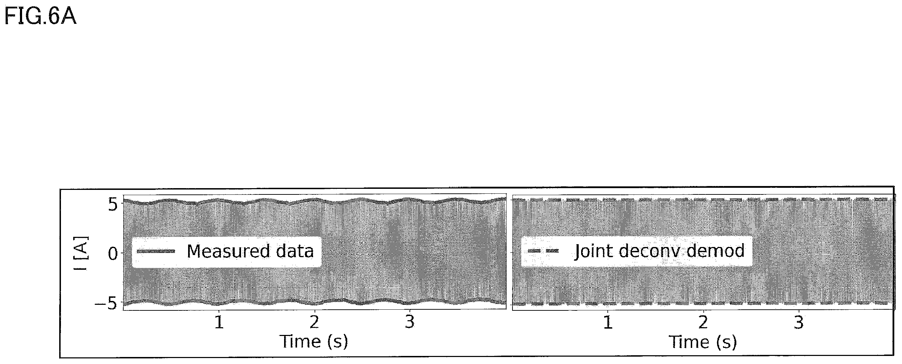

   Figure 6A is exemplar plots of stator current spectrum at one varying load condition (sinusoidal modulation) using Fourier transform and proposed blind deconvolution-decomposition spectrum analysis method.
[Fig. 6B]

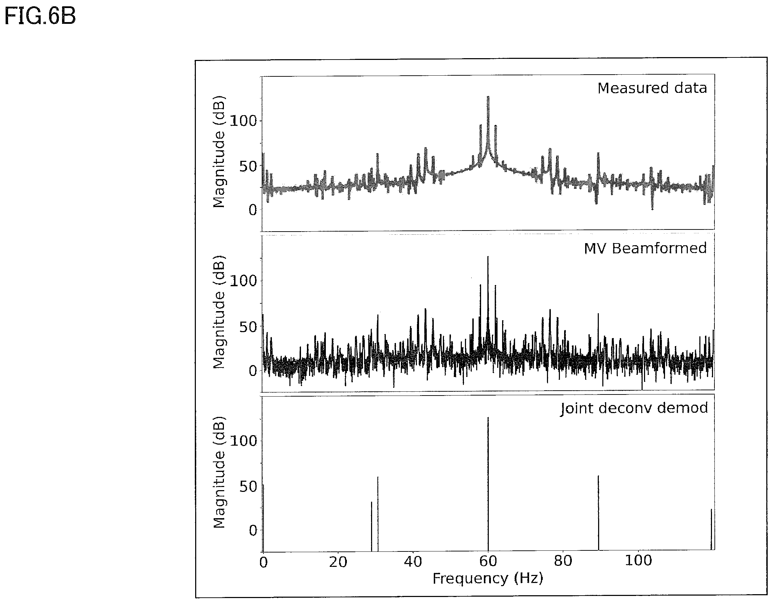

   Figure 6B is exemplar plots of stator current spectrum at one varying load condition (sinusoidal modulation) using Fourier transform and proposed blind deconvolution-decomposition spectrum analysis method.
[Fig. 7A]

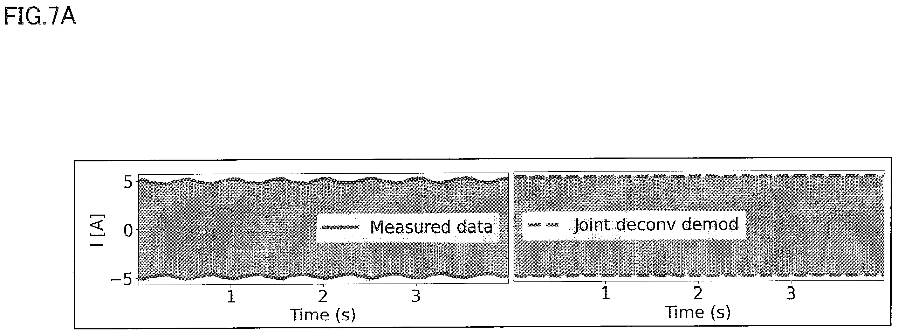

   Figure 7A is exemplar plots of stator current spectrum at another varying load condition (rectangular modulation) using Fourier transform and proposed blind deconvolution-decomposition spectrum analysis method.
[Fig. 7B]

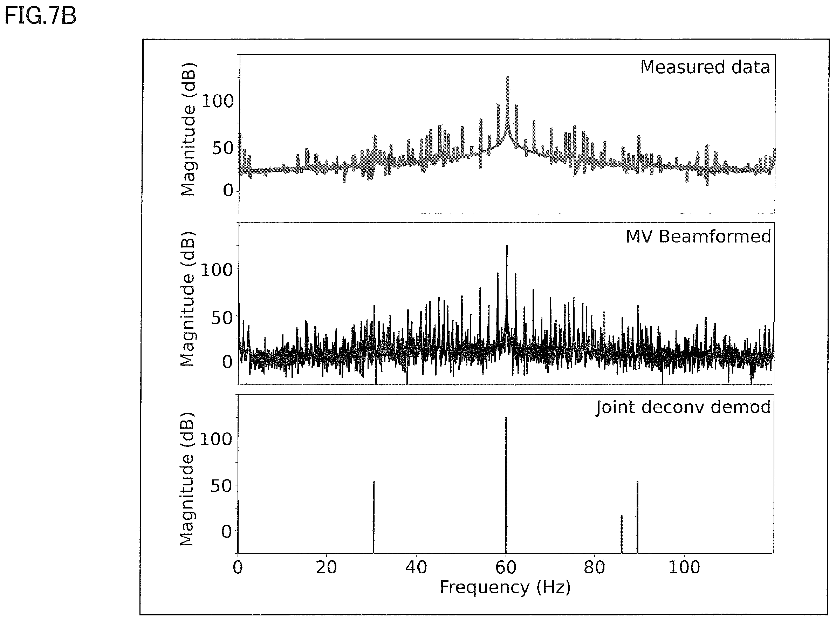

   Figure 7B is exemplar plots of stator current spectrum at another varying load condition (rectangular modulation) using Fourier transform and proposed blind deconvolution-decomposition spectrum analysis method.
[Fig. 8A]

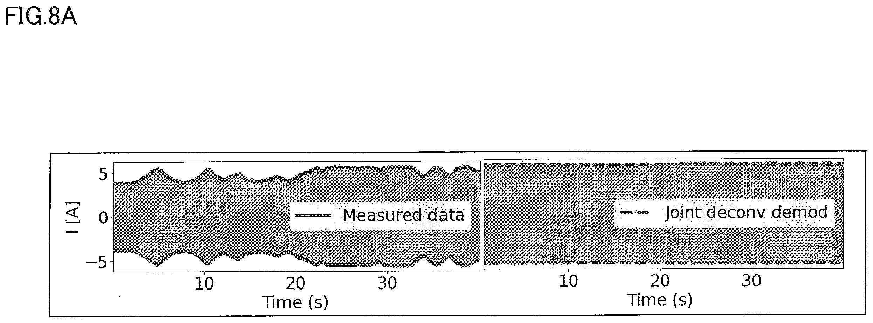

   Figure 8A is exemplar plots of stator current spectrum at another varying load condition (random modulation) using Fourier transform and proposed blind deconvolution-decomposition spectrum analysis method.
[Fig. 8B]

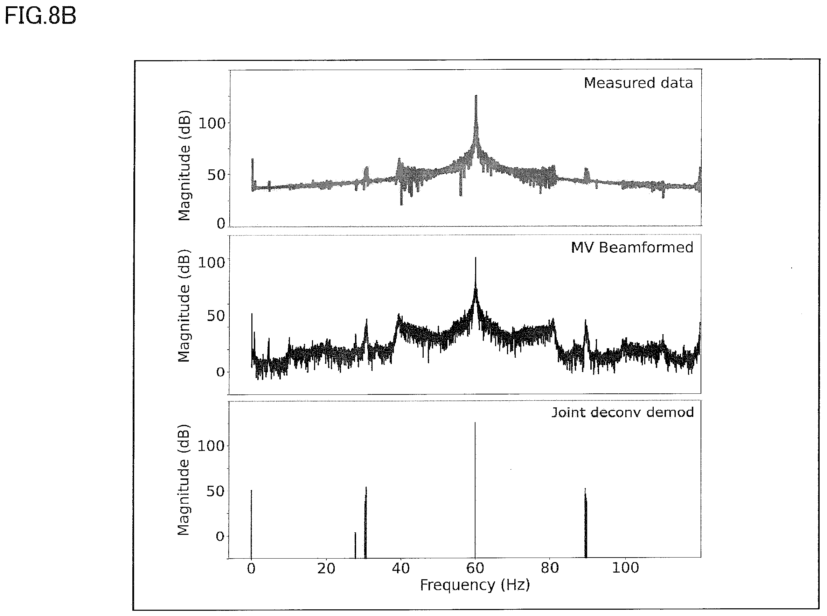

   Figure 8B is exemplar plots of stator current spectrum at another varying load condition (random modulation) using Fourier transform and proposed blind deconvolution-decomposition spectrum analysis method.

### [Description of Embodiments]

Various embodiments of the present invention are described hereafter with reference to the figures. It would be noted that the figures are not drawn to scale elements of similar structures or functions are represented by like reference numerals throughout the figures. It should be also noted that the figures are only intended to facilitate the description of specific embodiments of the invention. They are not intended as an exhaustive description of the invention or as a limitation on the scope of the invention. In addition, an aspect described in conjunction with a particular embodiment of the invention is not necessarily limited to that embodiment and can be practiced in any other embodiments of the invention.

Figure 1A is a schematic of a fault detection system 100 for controlling and monitoring an induction motor according to one embodiment of an invention.

The induction motor (system) 200 includes a rotor assembly 102, a stator assembly 104, a main shaft 106, and two main bearings 108. In this example, the induction motor 200 is a squirrel-cage induction motor. The induction motor 200 is connected to a load apparatus 210, which is mounted on the shaft of the rotor, such as a power fan or a transmission belt.

The controller 220 is powered by power supply 230 and can be used for monitoring and controlling the operation of the induction motor 200 in response to various inputs in accordance with embodiments of the present invention. For example, the controller 220 connected to the induction motor 200 can control the speed of the induction motor based on inputs received from the fault detection system 100 configured to acquire data pertaining to operating conditions of the induction motor 200 from the current sensor 150. According to certain embodiments, the electrical signal of the current sensor150 can be current from one or more of the multiple phases of the induction motor. More specifically, in the case of the induction motor is a 3-phase induction motor, the current sensor senses the current data from the three phases of the 3-phase induction motor. While certain embodiments of the present invention will be described with respect to a multi-phase induction motors, other embodiments of the present invention can be applied to other multi-phase electromechanical machines.

Some embodiments of the present invention describe a system for fault detection in an electric machine, such as the induction motor 200. The system configured for detection includes a fault-detection system 100 for detecting the presence of a faulty condition of a rotor 102, including eccentricity fault, within the induction motor assembly. In one embodiment, the fault detection system 100 is implemented as a sub-system of the controller 220. In alternative embodiment, the fault-detection system 100 is implemented using a separate processor. The fault-detection system 100 may be a hardware circuit module that is operatively connected to the controller 220. In some implementations the fault-detection system 100 and the controller 220 can share the information. For example, the fault detection system 100 can reuse sensor data used by the controller to control the operation of the induction motor.

Further, the fault-detection system 100 includes a processor 110, a memory 120, a fault detection program 121 stored in the memory 120 when the instructions of the program are performed by the processor 110. The fault-detection system 100 further includes a sensor interface 130 configured to acquire signals from the current sensor 150. The interface 130 includes A/D (analog/digital) and A/D (analog/digital) coverts to perform data communication with the processor1 10, the memory 120, the fault detection program, a user interface 140 and the current sensor 150. The processor 110 may be multiple processors, and the memory 120 may be a memory module that includes multiple memories. The processor 110 is configured to execute the fault signature detection program 121 by receiving the signals of stator and rotor currents of the induction motor 200 via the current sensor 150 connected to the fault-detection system 100 using the sensor interface 130.

The user interface 140 is configured to connect to a keyboard and a display unit configured indicate the normal/fault status information of the induction motor 200 in response to the output of the fault-detection module 200.

Figure 1B is a schematic of a fault detection system operated by a user (operator) via a network 250 for controlling and monitoring an induction motor according to one embodiment of an invention. In this case, the fault-detection system 100 may be included in an operating system of induction motors located at the site of the user/operator or the outsied of the site of the operator. When the fault-detection system 100 determines that a severe fault is caused in the induction machine 200 based on the sensor signal of the current sensor 150 via the network (communication network) 250 during the operation of the induction machine (induction motor) 200, the fault-detection system 100 can transmit a control signal indicative of the level of a fault level caused in the induction machine 200 to the controller 220 via the network 250 such that the controller 220 reduces an operation speed of the induction machine to a safety level or even stops the induction machine. For instance, the controller 220 slows down or stops operating the induction machine 200 according to the control signal indicating the fault level of the determined fault by the fault-detection system 100 based on a preprogrammed algorithm (not shown in the figure) stored in the memory of the controller 200. The control signal can be indicative of the operation status of the induction machine 200. For instance, the control signal can be indicative of the normal operations of the induction machine 200 or the level of a fault level caused in the indcutin machine 200. The controller 220 includes a display monitor system (not shown) and a user interface (not shown) configured to input a control command to the induction machine 200 such that an operator can control the operations of the induction machine 200 by inputting the control command that causes the induction machine 200 slow down or stop the operations of the induction machine 200. Further, when the controller 220 receives the control signal from the fault-detection system 100, the display monitor system having a monitor and a graphical user interface (GUI) can display the status of the operations of the induction machine 200 on a monitor of the display monitor system, in which the status of the operations indicates the normal operations of the induction machine 200 or the level of the fault detected by the fault-detection system 100.

In some cases, the calibrations of the current sensor 150 can be performed based on the sensor calibration program (not shown in the figure) stored in the memory of fault-detection system 100. In some cases, the network 250 may be an optical fiber network, a wireless network, an internet network, or a data communication network consisting of at least two combinations among the optical fiber network, the wireless network, and the internet network.

This configuration can be a maintenance system managed by a user/client, who operates the induction machine system 20 separately located from the site of the induction machine. For instance, this system configuration can be used for a power generating system operated by a user, and a train system for controlling the induction motors driving the trains. In some cases, when the fault-detection system 100 detects a site of the induction machine is separated from a site of the fault detection system, the data communication between the site of the induction machine and the site of the fault detection system is performed via a network. The network 250 may be an optical fiber network, a wireless network, an internet network, or a data communication network consisting of at least two combinations among the optical fiber network, the wireless network, and the internet network.

Further, the fault detection system is included as part of a maintenance system of a user. When the determined fault level (for example eccentricity) of the induction machine is equal to or greater than a critical threshold level, the fault detection system produces a control command and transmits the control signal of the control command to the controller 220 of the induction machine 200 via a network 250 using the sensor interface/control interface 130 to slow down or stop operating the induction machine 200.

Figure 2 is a block diagram of the fault detection process for an induction machine operating at varying operating conditions according to embodiments of the present invention. When the motor 200 is running with a varying load 210, the motor current is monitored using a sensor interface 130 by constantly measuring the stator current using the current sensor 150. Through the monitoring motor current process 410, a time-domain current 415 is measured and saved at a certain time interval for spectral analysis 420 using the proposed blind deconvolution-decomposition spectrum analysis method, resulting a frequency-domain spectrum 425 corresponding to a constant operating condition, with the varying load influence removed. Based on the frequency-domain spectrum, fault signature at certain frequency, for example, frequency components at approximately 30Hz and approximately 90Hz for eccentricity fault when the operating frequency is 60Hz, is extracted, where the fault signature magnitude is used to if there is a fault or not 440. If the fault component of the fault signature magnitude is greater than a certain value (threshold amplitude), for example, approximately 1/100 (-40dB) of the operating frequency component at 60Hz, the fault detection system determines that a fault is detected, and a control command (control signal) 450 is sent to the control circuit of the controller of the induction motor to slow down or stop the motor for safety purpose. Further, the control command can indicate different fault types, different fault levels and fault positions based on the detected frequency components and the signal mangitude of the fault singnature. For exmaple, if the current intensity on bearing fault signature frequency increases, a bearing fault is detected. Otherwise, the fault detection system keeps monitoring the stator current. In some cases, when the fault detection system does not detect a fault based on the threshold, the fault detection system produces and transmits a normal command indicative of the normal operations of the induction motor to the display of the controller, causing the GUI of the display to show a sign/text indicating a normal operation status on the display.

Without loss of generality, we consider a three-phase motor operating at an open-loop condition, driving a varying load 210. For time *t* ∈ *R,* let *iₛ*(*t*) and *iᵣ*(*t*) be the time-domain stator and rotor currents respectively, and *uₛ*(*t*) and *uᵣ*(*t*) denote the stator and the rotor voltages respectively, all in the space vector representation. The relationships between *iₛ, iᵣ, uₛ,* and *uᵣ* is given by $u = Z i + L \frac{d i}{dt}$ (1) where *i*(*t*) *=* [*iₛ*(*t*) *iᵣ*(*t*)]*^{T}*, ***u***(*t*) *=* [*uₛ*(*t*) *uᵣ*(*t*)]*^{T}*, and ***Z** =* $\left[\begin{matrix}{R}_{s} & 0 \\ - j Ω M & {R}_{r} - j Ω {L}_{r}\end{matrix}\right]$ and $L = \left[\begin{matrix}{L}_{s} & M \\ M & {L}_{r}\end{matrix}\right]$ are impedance and inductance matrices respectively with parameters defined as follows. *Rₛ* and *Rᵣ* represent stator and rotor resistance respectively, *Lₛ, Lᵣ,* and M denote the stator, rotor, and mutual inductance respectively, and Ω is the mechanical angular velocity of the rotor. In the frequency domain, motor currents can be formulated according to (1) as $\left[\begin{matrix}{I}_{s} \left(ω\right) \\ {I}_{r} \left(ω\right)\end{matrix}\right] = {\left(Z+jωL\right)}^{- 1} \left[\begin{matrix}{U}_{s} \left(ω\right) \\ {U}_{r} \left(ω\right)\end{matrix}\right] ,$ (2) where *ω =* 2*πf* is the angular frequency. Therefore, the transfer function corresponding to the stator and rotor currents can be expressed in the frequency domain as $H \left(ω\right) = \frac{{I}_{s} \left(ω\right)}{{I}_{r} \left(ω\right)} = \frac{a + jbω}{c + jdω} ,$ (3) where *a, b, c,* and *d* are complex numbers related to the motor parameters and its rotational angular speed Ω. When the motor is operating at a steady state, meaning the angular speed Ω is a constant, *H*(*ω*) is characterized by motor parameters, which could be different for different motors. When the motor is operating at a varying speed or a transient state, *H*(*ω*) is also related to the rotational speed Ω.

On the other hand, since the load is varying slowly, we assume that the motor can track the load change and provide enough electromagnetic torque to drive the load. Let *τ*(*t*) be the electromagnetic torque as a function of time, *iₛₛ*(*t*) be the steady-state stator current under constant load in noiseless conditions. The electromagnetic torque can be approximated by either the stator current or the rotor current, or combination of the stator current and the rotor current using space vectors as $τ \left(t\right) = {κi}_{s} \left(t\right) * {i}_{r} \left(t\right) \approx {κi}_{ss} \left(t\right) * {i}_{r} \left(t\right) ,$ (4) where *κ* is a proportionality constant, the superscript * represents the Hermitian transpose. This implies ${i}_{r} \left(t\right) = \frac{τ \left(i\right)}{{\left‖{κi}_{SS}\left(t\right)\right‖}^{2}} {i}_{SS} \left(t\right) ≜ m \left(t\right) x \left(t\right) ,$ (5) where $m \left(t\right) = \frac{τ \left(t\right)}{{\left‖{κi}_{ss}\left(t\right)\right‖}^{2}}$ is a modulation signal related to the electromagnetic torque (or approximate load) and *x*(*t*) is the underlying steady-state stator current to be explored. Combining (3) and (5), we have ${i}_{s} \left(t\right) = h \left(t\right) ⊗ {i}_{r} \left(t\right) = h \left(t\right) ⊗ \left[m\left(t\right)x\left(t\right)\right] ,$ (6) where ⊗ represents the convolution operation.

Let y(t) denote the measured stator current with additive noise. Therefore, the measured stator current with varying operating conditions can be modeled as $y \left(t\right) = h \left(t\right) ⊗ \left[m\left(t\right)x\left(t\right)\right] + n \left(t\right) ,$ (7) where n(t) represents the measured noise.

Figure 4 is an exemplar plot of stator current in the time-domain of an induction machine operating at varying operating conditions. When the load m(t) is varying, the amplitude of y(t) is not a constant, but varying with load.
Equivalently we have the stator current model in frequency domain $Y \left(ω\right) = H \left(ω\right) \left[M\left(ω\right)⊗X\left(ω\right)\right] + N \left(ω\right) .$ (8)

To rewrite our measurement model in discrete-time (DT) domain, we define ***s*** = [*s*[*t*₀]*, s*[*t*₁]*, ... , s*[*t*_{*N*-1}]]*^{T}* as a vector of samplings of a time-domain signal s(t) with sampling frequency *Fₛ*, where $t ∈ \left\{{t}_{n}=\frac{n}{{F}_{s}}\right\}$ *, n* = 0, ... , *N* - 1}. Let *S*[*f*] denote the frequency-domain vector of the discrete-time Fourier transform (DTFT) of ***s**, i.e. S[f] = Fs,* where ***F*** ∈ *C*^{*N*×*N*} denotes the DTFT operation.

Following the above notation, we use ***x, y, m, h, n*** E *C^{N}* to represent the vectors of samplings from *x*(*t, y*(*t*), *m*(*t*)*, h*(*t*)*,* and *n*(*t*) respectively. Thus, the time-domain signal model described in (7) can be rewritten as follows: $y = h ⊗ \left(m⊙x\right) + n ,$ (9) where ⊙ represents the element-wise product of two vectors.

Obtaining an estimate of ***x, m**,* and ***h*** from ***y*** amounts to solving a joint blind deconvolution-demodulation optimization problem. This is an ill-posed inverse problem and requires prior knowledge about the nature of ***x**, **m***, and ***h**.* Based on the physical model of the stator current in the presence of load, the following assumptions about the nature of ***x, m*,** and ***h*** are made.

First, we know that ***x*** contains a strong operating frequency signal, its harmonics, and other periodic signals that correspond to the motor fault. In the frequency domain, ***x*** is typically of the form $X \left[f\right] = {\sum }_{i = 1}^{{n}_{S}} {A}_{i} δ \left[f-{f}_{i}\right] ,$ (10) where *Aᵢ* is the amplitude of frequency component presented at *fᵢ*. Therefore, we assume that **Fx** is a sparse vector.

Second, we assume that the random load is slowly varying in time. This translates to the assumption that *m*(*t*) is band limited with half-bandwidth *f*ₘ, i.e., $supp \left(m\right) = \left[-{f}_{m}; {f}_{m}\right] .$ (11)

Lastly, based on the aforementioned nature of the motor impulse response, we assume that the form of the magnitude frequency response *h*(*t*) is of the form $\left|H\left[f\right]\right| = {H}_{α , β} \left[f\right] = \sqrt{\frac{1 + 4 {πα}_{1} {β}_{1} f + 4 {π}^{2} {β}_{1}^{2} {f}^{2}}{1 + 4 {πα}_{2} {β}_{2} f + 4 {π}^{2} {β}_{2}^{2} {f}^{2}}} ,$ (12) where ***α*** = [*α*₁ *α*₂]*^{T}, **β*** = [*β*₁ *β*₂]*^{T},* related to *a, b, c,* and *d* in (3), ***α**, **β*** ∈ *R²* |*α*₁|, |*α*₂| < 1(*i.e.*||*α*||_{∞} < 1), and the phase ∠*H*[*f*] needs to be estimated from the measured data.

Based on the prior assumptions described above, the problem of MCSA fault detection under varying operating conditions can be cast as the following generalized optimization problem to jointly estimate ***x**, **m***, and ***h**,* $\begin{matrix}\left\{\hat{h}, \hat{m}, \hat{x}\right\} = {argmin}_{\left\{h, m, x\right\}} L \left(h, m, x\right) + {λ}_{x} {ψ}_{x} \left(x\right) \\ = {argmin}_{\left\{h, m, x\right\}} {\left‖y-h⊗\left(m⊙x\right)\right‖}_{2}^{2} + {λ}_{x} {\left‖σ⊙Fx\right‖}_{1} \\ s . t . supp \left(m\right) = \left[-{f}_{m};{f}_{m}\right] ; \left|H\left[f\right]\right| = {H}_{α , β} \left[f\right] ,\end{matrix}$ (13) where *ψₓ*(***x***) *=* ||**σ** ⊙ ***Fx***||₁ is a weighted *l*₁ penalty with weights σ to promote sparsity in Fx. Although a similar optimization problem arises in blind demodulation, the problem at hand presents significant challenges unique to the physical measurement system. First, the signal ***x*** is affected by both an unknown modulating signal and an unknown filter. Second, ***x*** may contain very weak periodic signatures of the motor fault, which are typically 40dB to 60dB lower in power than the main operating power frequency component at *fₛ* . Moreover, similar to blind deconvolution or demodulation, this is a non-convex optimization problem. Therefore, to find a suitable solution, a good initialization of ***x, m*,** and ***h*** is necessary. Our approach to solving this problem is inspired by the proximal alternating linearized minimization (PALM) framework, with careful initialization heuristics and regularization that are described below. Figure 3 is a detailed description of the spectrum analysis of stator current measured from an induction machine operating at varying conditions using a blind deconvolution-decomposition method according to some embodiments of the present invention.

In order to make our approach robust to noise, we preprocess the measurements using denoising via minimum-variance (MV) beamforming. In the minimum-variance beam-forming method, the time-domain stator current under test is segmented into multiple overlapped time sequences with a fixed time shift. Each sequence is treated as an independent measurement of a virtual current sensor. Since the time difference between adjacent sequences is identical, these virtual sensors form a linear virtual sensor array. The spectrum analysis problem is then converted to a beam-forming problem of a linear array in the frequency domain. The minimum variance beam-forming method minimizes the noise variance of spectrum at each frequency with respect to weights on the frequency component of different sequences. Therefore, it is effective at reducing the noise in the measured current signal, but unable to remove structured artifacts due to the varying load.

Next, since it is known that *x* is sparse in the frequency domain and contains the fundamental frequency and harmonics of the operating frequency *fₛ*, we initialize *x* as a linear combination of 2*nₛ* harmonics of *fₛ,* with the amplitude of each harmonic being equal to the amplitude of that harmonic in the measured data. ${X}_{init} \left[f\right] = {\sum }_{k = - {n}_{s}}^{{n}_{S}} Y \left[f\right] ⋅ δ \left[f-{f}_{s , k}\right] ,$ (14) where *f_{s,k}* is the k^{th} harmonic frequency.

Next, we initialize ∠*H*[*f*] *=* 0, and |*H*[*f*]| = *H_{α,β}*[*f*]*,* where *α* and *β* are to be estimated from the measured data. Considering that *X*[*f*] is a sparse weighted sum of delta functions, the forward process in (8) results in *M*[*f*] being mirrored onto the peak locations *f_{s,k}* in the measured data, and further distorted by *H*[*f*]*.* Therefore, templates of *M*[*f*] can in-principle be obtained from the data by windowing the data around *f_{s,k}* and correcting for the distortion due to H[f]. Since |*H*[*f*]| is of the form described in (12), these distortion-corrected templates of *M*[*f*] depend upon the choice of *α* and *β* used to correct for the *H*[*f*]-distortion. The H[f]-distorted template of M[f] at location *f_{s,k}* can be obtained from the measured data as: ${M}^{\left(k\right)} \left[f\right] = \frac{Y \left[f+{f}_{s , k}\right]}{Xinit \left[{f}_{s , k}\right]} = \frac{Y \left[f+{f}_{s , k}\right]}{Y \left[{f}_{s , k}\right]} ,$ (15) for |*f*| *< f_{b}* according to (11).

The schematic diagram of estimating the system response vector of the induction machine 200, and the modulation vector of the load *Mᵢₙᵢₜ* is shown in Figure 5.

Now, for the true value of *α* and *β*, the magnitudes of the distortion-corrected templates $\left|\frac{{M}^{\left(k\right)} \left[f\right]}{{H}_{α , β} \left[f+{f}_{s , k}\right]}\right|$ in each small frequency window in Figure 5 must be close to each other, as well as to the true value of |*M*[*f*]|*.* Therefore, the optimal value of *α, β*, and the initial estimate of *M*[*f*] are computed via the following optimization problem: $\begin{matrix}\left\{\hat{α}, \hat{β}, {M}_{init}\right\} = {argmin}_{α , β , M} L ′ \left(α, β, M\right) \\ = {argmin}_{α , β , M} {\sum }_{k} {ς}_{k}^{2} {\left‖M\left[f\right]-\frac{\left|{M}^{\left(k\right)}\left[f\right]\right|}{{H}_{α , β} \left[f+{f}_{s , k}\right]}\right‖}_{2}^{2}\end{matrix}$ (16) where 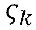 is the signal-to-noise ratio (SNR) at the k^{th} harmonic. We adopt an alternating minimization scheme to solve this problem until convergence. For any feasible value of *α* and *β*, minimizing *L*'(*α, β, M*) with respect to M alone is straightforward, and the minimizer is given by ${{M}^{˜}}_{α , β} \left[f\right] = \frac{1}{{\sum }_{l} {ς}_{l}^{2}} {\sum }_{l} {ς}_{l}^{2} \frac{\left|{M}^{\left(l\right)}\left[f\right]\right|}{{H}_{α , β} \left[f+{f}_{s , l}\right]}$ (17)

Given the solution of *Mᵢₙᵢₜ* in (17), the values of *α* and *β* are then obtained by solving (16) using a black-box nonlinear least-squares solver.

Using the initialization of the optimization variables obtained, the estimates of the variables are obtained via the following optimization problem representing joint blind deconvolution and demodulation. Similar problems have been solved using alternating minimization approaches in the context of blind deconvolution.

These approaches alternately minimize the objective with respect to ***m*** and ***x*** iteratively. Although simple to describe, it has been shown that the alternating minimization approach is highly sensitive to initialization, and convergence can only be obtained under restrictive conditions. A proximal alternating linearized minimization (PALM) scheme addresses some of these issues by replacing the alternating minimization steps by proximal/projected gradient steps: ${x}_{k + 1} = prox \left[\left(\frac{{λ}_{x}}{2}\right){ψ}_{x}\right] \left({x}_{k}-{η}_{x}{∇}_{x}L\left({x}_{k}, {m}_{k}\right)\right) ,$ (18) ${m}_{k + 1} = {proj}_{\left\{m\left|supp\left(m\right)=-\left[-{f}_{m},{f}_{m}\right]\right.\right\}} \left({m}_{k}-{η}_{m}L\left({x}_{k + 1}, {m}_{k}\right)\right) ,$ (19) where for a function *ψ*: *c^{N}* → *R* and *v* ∈ *C^{N}*, the proximal operator is defined as $prox \left[ψ\right] \left(x\right) = {argmin}_{w} ψ \left(w\right) + \frac{1}{2} {\left‖x-w\right‖}_{2}^{2}$ (20) and for a set ***S***, *projₛ*(***m***) is the projection of ***m*** onto ***S***. In our approach, the proximal-gradient steps for **x** and **m** are interspersed with updates to h. Also, from (7), once ***x̂*** is recovered, the stator current without varying load can be obtained by $\hat{s} = \hat{h} ⊗ \hat{x} ,$ (21) where ***ĥ*** and ***x̂*** are outputs of the optimization problem defined in (13). The entire proposed procedure is summarized in Figure 3. To examine our approach, we consider stator current data collected from a motor with eccentricity fault. The motor is operating at *fₛ =* 60Hz with either a periodically varying load or a randomly varying load. In the case of the periodically varying load, two variation patterns are considered: a sinusoidal variation and a rectangular variation with a frequency of 2Hz. In our approach, we set the half-bandwidth of ***m*** to be *fₘ* = 26Hz. The sparsity weight *σ*[*f*] is set to *e*^{-*ε*[*f*]}, where *ε*[*f*] is the smooth envelope of log |*Y* [*f*]|*.* The signal-to-noise ratio (SNR) at peak location *f_{s,k}* is computed as ${ς}_{k} = \frac{\left|Y\left[{f}_{s , k}\right]\right|}{η}$, with *η* being the average noise level in a 1 Hz window on either side of the template *support* [*f_{s,k} - fₘ, f_{s,k}* + *fₘ*]. We compare our approach to the MV-beamforming method, which is effective at reducing the noise in the measured current signal, but unable to remove structured artifacts due to the varying load.

Figures 6A and 6B are exemplar plots of stator current spectrum at one varying load condition (sinusoidal modulation) using Fourier transform and proposed blind deconvolution-decomposition spectrum analysis method, respectively.

These plots show that as expected, MV beamforming is successful in denoising the signal, because it effectively destroys the noise by averaging over the random phase components of the noise, while adding structured periodic signal sections constructively. However, as expected, MV beamforming is unable to remove the artifacts due to load variation, since these artifacts are structured. The proposed approach is effective in removing the effects of load variation. The eccentricity fault signatures can be clearly seen around 30Hz and 90Hz when the corresponding rotor frequency *fᵣ =* 30Hz, which agrees with the MSCA-based fault detection model.

Figures 7A and 7B are exemplar plots of stator current spectrum at another varying load condition (rectangular modulation) using Fourier transform and proposed blind deconvolution-decomposition spectrum analysis method, respectively. Similarly, the proposed approach significantly reduced the impact of modulation due to the varying load.

Figures 8A and 8B are exemplar plots of stator current spectrum at another varying load condition (random modulation) using Fourier transform and proposed blind deconvolution-decomposition spectrum analysis method, respectively. From the time-domain plot, the impacts of modulation are reduced by the proposed algorithm. In the frequency-domain plot, the proposed approach is effective in reducing the noise as well as the effects of the random convolution and modulation, and is able to retain the eccentricity fault signatures at around 30Hz and 90Hz respectively.

The above-described embodiments of the present invention can be implemented in any of numerous ways. For example, the embodiments may be implemented using hardware, software or a combination thereof. When implemented in software, the software code can be executed on any suitable processor or collection of processors, whether provided in a single computer or distributed among multiple computers. Such processors may be implemented as integrated circuits, with one or more processors in an integrated circuit component. Though, a processor may be implemented using circuitry in any suitable format.

Also, the embodiments of the invention may be embodied as a method, of which an example has been provided. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

Use of ordinal terms such as "first," "second," in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Although the invention has been described by way of examples of preferred embodiments, it is to be understood that various other adaptations and modifications can be made within the scope of the invention

Therefore, it is the object of the appended claims to cover all such variations and modifications as come within the scope of the invention.

## Claims

1. A fault detection system (100) for detecting faults of an induction motor (200) operating at varying operating conditions indicative of varying load conditions (210), varying speed conditions or combination thereof, comprising:
a sensor device (150) connected to a power cable of the induction motor (200), wherein the sensor device (150) is configured to measure a stator current of the induction motor (200) under the varying operating conditions via the power cable;
a memory (120) configured to store a computer-implemented fault detection method;
a signal processor (110) configured to perform steps of the computer-implemented fault detection method, wherein the steps comprise:
forming a stator current vector by sampling the measured stator current using on a sampling frequency according to time sequences;
reducing noise of the stator current vector using a minimum-variance (MV) beam forming method; **characterised by** further comprising:
formulating a joint blind deconvolution-demodulation optimization problem based on the stator current vector of a steady operating condition, a response vector of the induction motor (200), a modulation vector of varying operating conditions, and a noise vector to satisfy the measured stator current vector with reduced noise;
estimating the stator current vector of the steady operating condition, the response vector of the induction motor (200), the modulation vector of the varying operating conditions, and the noise vector by solving the joint blind deconvolution-demodulation optimization problem;
extracting fault signatures from a clean stator current estimate vector, wherein the clean stator current estimate vector is generated by use of the estimated response vector and the estimated stator current vector;
producing a control command to a controller (220) of the induction motor (200) if at least one of the fault signatures is greater than a threshold and controlling the induction motor (200) by transmitting the control command that causes the controller (220) to reduce an operation speed of the induction motor (200) to a safety level, otherwise producing and transmitting a normal command indicative of the normal operations of the induction motor (200) to the controller (220).

2. The fault detection system (100) of claim 1, wherein the signal processor denoises the stator current using a minimum-variance (MV) beamforming method before the computing.

3. The fault detection system (100) of claim 1, wherein the monitor of the controller (220) displays the faulty operation sign in response to receiving the control signal.

4. The fault detection system (100) of claim 1, wherein the control signal is indicative of a fault level and fault positoin caused in the induction motor (200).

5. The fault detection system (100) of claim 1, wherein for the varying operating conditions, an electromagnetic torque is approximated by either the stator current or a rotor current of the induction motor (200) and/or wherein a half-bandwidth of a modulation signal related to the electromagnetic torque is approximately set a half of an operating frequency of the induction motor (200).

6. The fault detection system (100) of claim 1, wherein the stator current vector of the steady operating condition is initialized as a linear combination of harmonics of an operating frequency of the induction motor (200) and/or wherein the fault signatures are determined by performing a spectrum analysis program on the clean stator current estimate vector.

7. The fault detection system (100) of claim 1, wherein the solving further includes
initializing the response vector and the modulation vector; and
updating, iteratively, the stator current vector, the response vector, and the modulation vector until the updating reaches convergence.

8. The fault detection system (100) of claim 1, wherein for the varying operating conditions, an electromagnetic torque is approximated by the stator current and a rotor current of the induction motor (200).

9. A computer-implemented method for detecting faults of an induction motor (200) operating at varying operating conditions indicative of varying load conditions (210), varying speed conditions or combination thereof, comprising:
measuring a stator current of the induction motor (200) under the varying operating conditions via a current sensor (150) connected to a power cable of the induction motor (200);
forming a stator current vector by sampling the measured stator current using on a sampling frequency according to time sequences;
reducing noise of the stator current vector using a minimum-variance (MV) beam forming method; **characterised by** further comprising:
formulating a joint blind deconvolution-demodulation optimization problem based on the stator current vector of a steady operating condition, a response vector of the induction motor (200), a modulation vector of varying operating conditions, and a noise vector to satisfy the measured stator current vector with reduced noise;
estimating the stator current vector of the steady operating condition, the response vector of the induction motor (200), the modulation vector of the varying operating conditions, and the noise vector by solving the joint blind deconvolution-demodulation optimization problem;
extracting fault signatures from a clean stator current estimate vector, wherein the clean stator current estimate vector is generated by use of the estimated response vector and the estimated stator current vector;
producing a control command to a controller (220) of the induction motor (200) if at least one of the fault signatures is greater than a threshold and controlling the induction motor (200) by transmitting the control command that causes the controller (220) to reduce an operation speed of the induction motor (200) to a safety level, otherwise producing and transmitting a normal command indicative of the normal operations of the induction motor (200) to the controller (220).

10. The method of claim 9, further denoises the stator current using a minimum-variance (MV) beamforming method before the computing.

11. The method of claim 9, wherein the monitor of the controller (220) displays a faulty operation sign on a display of the controller (220) in response to receiving the control command.

12. The method of claim 9, wherein the control command is indicative of a fault level and fault position caused in the induction motor (200).

13. The method of claim 9, wherein for the varying operating conditions, an electromagnetic torque is approximated by either the stator current or a rotor current of the induction motor (200) and/or wherein a half-bandwidth of a modulation signal related to the electromagnetic torque is approximately set a half of an operating frequency of the induction motor (200).

14. The method of claim 9, wherein the stator current vector of the steady operating condition is initialized as a linear combination of harmonics of an operating frequency of the induction motor (200) and/or wherein the fault signatures are determined by performing a spectrum analysis program on the clean stator current estimate vector.

15. The method of claim 9, wherein the solving further includes
initializing the response vector and the modulation vector; and
updating, iteratively, the stator current vector, the response vector, and the modulation vector until the updating reaches convergence and/or wherein for the varying operating conditions, an electromagnetic torque is approximated by the stator current and a rotor current of the induction motor (200).

## Patentansprüche

1. Fehlererfassungssystem (100) zum Erfassen von Fehlern eines Induktionsmotors (200), der unter variierenden Betriebszuständen arbeitet, die auf variierende Lastbedingungen (210), variierende Drehzahlbedingungen oder eine Kombination daraus hinweisen, umfassend:
eine Sensorvorrichtung (150), die mit einem Stromkabel des Induktionsmotors (200) verbunden ist, wobei die Sensorvorrichtung (150) eingerichtet ist, über das Stromkabel einen Statorstrom des Induktionsmotors (200) unter den wechselnden Betriebszuständen zu messen;
einen Arbeitsspeicher (120), der zum Speichern eines computerimplementierten Fehlererfassungsverfahrens eingerichtet ist;
einen Signalprozessor (110), der eingerichtet ist, Schritte des computerimplementierten Fehlererfassungsverfahrens auszuführen, wobei die Schritte Folgendes umfassen:
Bilden eines Statorstromvektors durch Abtasten des gemessenen Statorstroms mit einer Abtastfrequenz gemäß zeitlicher Abfolge;
Rauschminderung des Statorstromvektors unter Verwendung eines Strahlformungsverfahrens mit minimaler Varianz (MV); **gekennzeichnet durch** das weitere Bereitstellen von:
Erstellen eines gemeinsamen Optimierungsproblems der blinden Dekonvolution und Demodulation auf der Grundlage des Statorstromvektors im stabilen Betriebszustand, eines Antwortvektors des Induktionsmotors (200), eines Modulationsvektors für wechselnde Betriebszustände und eines Rauschvektors, um den gemessenen Statorstromvektor bei reduziertem Rauschen zu erfüllen;
Schätzen des Statorstromvektors im stabilen Betriebszustand, des Antwortvektors des Induktionsmotors (200), des Modulationsvektors der wechselnden Betriebszustände und des Rauschvektors durch Lösen des gemeinsamen Optimierungsproblems der blinden Dekonvolution und Demodulation;
Extrahieren von Fehlersignaturen aus einem bereinigten Statorstrom-Schätzvektor, wobei der bereinigte Statorstrom-Schätzvektor unter Verwendung des geschätzten Antwortvektors und des geschätzten Statorstromvektors erzeugt wird;
Erzeugen eines Steuerbefehls an eine Steuereinheit (220) des Induktionsmotors (200), wenn mindestens eine der Fehlersignaturen einen Schwellenwert überschreitet, und Steuern des Induktionsmotors (200) durch Übertragen des Steuerbefehls, der die Steuereinheit (220) veranlasst, eine Betriebsdrehzahl des Induktionsmotors (200) auf ein Sicherheitsniveau zu senken; andernfalls Erzeugen und Übertragen eines Normalbefehls, der den Normalbetrieb des Induktionsmotors (200) an die Steuereinheit (220) signalisiert.

2. Fehlererfassungssystem (100) nach Anspruch 1, wobei der Signalprozessor den Statorstrom vor dem Berechnen mithilfe eines Strahlformungsverfahrens mit minimaler Varianz (MV) entrauscht.

3. Fehlererfassungssystem (100) nach Anspruch 1, wobei der Bildschirm der Steuereinheit (220) als Reaktion auf den Empfang des Steuersignals das Störungssymbol anzeigt.

4. Fehlererfassungssystem (100) nach Anspruch 1, wobei das Steuersignal ein Fehlerlevel und eine Fehlerposition angibt, die im Induktionsmotor (200) verursacht wurden.

5. Fehlererfassungssystem (100) nach Anspruch 1, wobei für die variierenden Betriebszustände ein elektromagnetisches Drehmoment entweder durch den Statorstrom oder durch einen Rotorstrom des Induktionsmotors (200) angenähert wird und/oder wobei eine halbe Bandbreite eines auf das elektromagnetische Drehmoment bezogenen Modulationssignals annähernd auf die Hälfte einer Betriebsfrequenz des Induktionsmotors (200) eingestellt wird.

6. Fehlererfassungssystem (100) nach Anspruch 1, wobei der Statorstromvektor im stabilen Betriebszustand als lineare Kombination von Harmonischen einer Betriebsfrequenz des Induktionsmotors (200) initialisiert wird und/oder wobei die Fehlersignaturen durch Ausführen eines Spektralanalyseprogramms auf den bereinigten Statorstrom-Schätzvektor ermittelt werden.

7. Fehlererfassungssystem (100) nach Anspruch 1, wobei das Lösen ferner umfasst:
Initialisieren des Antwortvektors und des Modulationsvektors; und
Iteratives Aktualisieren des Statorstromvektors, des Antwortvektors und des Modulationsvektors, bis das Aktualisieren konvergiert.

8. Fehlererfassungssystem (100) nach Anspruch 1, wobei für die unterschiedlichen Betriebszustände ein elektromagnetisches Drehmoment durch den Statorstrom und einen Rotorstrom des Induktionsmotors (200) angenähert wird.

9. Computerimplementiertes Verfahren zum Erfassen von Fehlern eines Induktionsmotors (200), der unter variierenden Betriebszuständen arbeitet, die auf variierende Lastbedingungen (210), variierende Drehzahlbedingungen oder eine Kombination davon hindeuten, mit folgenden Schritten:
Messen eines Statorstroms des Induktionsmotors (200) unter den wechselnden Betriebszuständen mittels eines Stromsensors (150), der an ein Stromkabel des Induktionsmotors (200) angeschlossen ist;
Bilden eines Statorstromvektors durch Abtasten des gemessenen Statorstroms mit einer Abtastfrequenz gemäß zeitlicher Abfolge;
Rauschminderung des Statorstromvektors unter Verwendung eines Strahlformungsverfahrens mit minimaler Varianz (MV); **gekennzeichnet durch** das weitere Bereitstellen von:
Erstellen eines gemeinsamen Optimierungsproblems der blinden Dekonvolution und Demodulation auf der Grundlage des Statorstromvektors im stabilen Betriebszustand, eines Antwortvektors des Induktionsmotors (200), eines Modulationsvektors für wechselnde Betriebszustände und eines Rauschvektors, um den gemessenen Statorstromvektor bei reduziertem Rauschen zu erfüllen;
Schätzen des Statorstromvektors im stabilen Betriebszustand, des Antwortvektors des Induktionsmotors (200), des Modulationsvektors der wechselnden Betriebszustände und des Rauschvektors durch Lösen des gemeinsamen Optimierungsproblems der blinden Dekonvolution und Demodulation;
Extrahieren von Fehlersignaturen aus einem bereinigten Statorstrom-Schätzvektor, wobei der bereinigte Statorstrom-Schätzvektor unter Verwendung des geschätzten Antwortvektors und des geschätzten Statorstromvektors erzeugt wird;
Erzeugen eines Steuerbefehls an eine Steuereinheit (220) des Induktionsmotors (200), wenn mindestens eine der Fehlersignaturen einen Schwellenwert überschreitet, und Steuern des Induktionsmotors (200) durch Übertragen des Steuerbefehls, der die Steuereinheit (220) veranlasst, eine Betriebsdrehzahl des Induktionsmotors (200) auf ein Sicherheitsniveau zu senken; andernfalls Erzeugen und Übertragen eines Normalbefehls, der den Normalbetrieb des Induktionsmotors (200) an die Steuereinheit (220) signalisiert.

10. Verfahren nach Anspruch 9, bei dem der Statorstrom vor dem Berechnen zusätzlich mittels eines Strahlformungsverfahrens mit minimaler Varianz (MV) entrauscht wird.

11. Verfahren nach Anspruch 9, wobei der Bildschirm der Steuereinheit (220) als Reaktion auf den Empfang des Steuerbefehls ein Störungssymbol auf einer Anzeige der Steuereinheit (220) anzeigt.

12. Verfahren nach Anspruch 9, wobei der Steuerbefehl ein im Induktionsmotor (200) aufgetretenes Fehlerlevel und eine Fehlerposition angibt.

13. Verfahren nach Anspruch 9, wobei für die variierenden Betriebszustände ein elektromagnetisches Drehmoment entweder durch den Statorstrom oder durch einen Rotorstrom des Induktionsmotors (200) angenähert wird und/oder wobei eine halbe Bandbreite eines auf das elektromagnetische Drehmoment bezogenen Modulationssignals annähernd auf die Hälfte einer Betriebsfrequenz des Induktionsmotors (200) eingestellt wird.

14. Verfahren nach Anspruch 9, wobei der Statorstromvektor des stabilen Betriebszustands als lineare Kombination von Harmonischen einer Betriebsfrequenz des Induktionsmotors (200) initialisiert wird und/oder wobei die Fehlersignaturen durch Ausführen eines Spektralanalyseprogramms auf den bereinigten Statorstrom-Schätzvektor ermittelt werden.

15. Verfahren nach Anspruch 9, wobei das Lösen ferner umfasst:
Initialisieren des Antwortvektors und des Modulationsvektors; und
iteratives Aktualisieren des Statorstromvektors, des Antwortvektors und des Modulationsvektors, bis das Aktualisieren konvergiert, und/oder wobei für die unterschiedlichen Betriebszustände ein elektromagnetisches Drehmoment durch den Statorstrom und einen Rotorstrom des Induktionsmotors (200) angenähert wird.

## Revendications

1. Un système de détection de défauts (100) destiné à détecter des défauts d'un moteur à induction (200) fonctionnant dans des conditions de fonctionnement variables indicatives de conditions de charge variables (210), de conditions de vitesse variables ou d'une combinaison de celles-ci, comprenant :
un dispositif à capteur (150) connecté à un câble d'alimentation du moteur à induction (200), dans lequel le dispositif à capteur (150) est configuré pour mesurer un courant statorique du moteur à induction (200) dans les conditions de fonctionnement variables par l'intermédiaire du câble d'alimentation ;
une mémoire (120) configurée pour stocker une méthode de détection de défauts mise en œuvre par ordinateur ;
un processeur de signaux (110) configuré pour effectuer des étapes de la méthode de détection de défauts mise en œuvre par ordinateur, dans lequel les étapes comprennent :
la formation d'un vecteur de courant statorique par échantillonnage du courant statorique mesuré en utilisant une fréquence d'échantillonnage selon des séquences temporelles ;
la réduction du bruit du vecteur de courant statorique en utilisant une méthode de formation de faisceau à variance minimale (MV) ; **caractérisé en ce qu'**il comprend en outre :
la formulation d'un problème d'optimisation conjoint de déconvolution-démodulation aveugle basé sur le vecteur de courant statorique d'une condition de fonctionnement stable, un vecteur de réponse du moteur à induction (200), un vecteur de modulation de conditions de fonctionnement variables, et un vecteur de bruit pour satisfaire le vecteur de courant statorique mesuré avec un bruit réduit ;
l'estimation du vecteur de courant statorique de la condition de fonctionnement stable, du vecteur de réponse du moteur à induction (200), du vecteur de modulation des conditions de fonctionnement variables, et du vecteur de bruit en résolvant le problème d'optimisation conjoint de déconvolution-démodulation aveugle ;
l'extraction de signatures de défaut à partir d'un vecteur d'estimation de courant statorique propre, dans lequel le vecteur d'estimation de courant statorique propre est généré par utilisation du vecteur de réponse estimé et du vecteur de courant statorique estimé ;
la production d'une commande de contrôle destinée à un contrôleur (220) du moteur à induction (200) si au moins une des signatures de défaut est supérieure à un seuil et commandant le moteur à induction (200) en transmettant la commande de contrôle qui amène le contrôleur (220) à réduire une vitesse de fonctionnement du moteur à induction (200) à un niveau de sécurité, produisant et transmettant sinon une commande normale indicative des fonctionnements normaux du moteur à induction (200) au contrôleur (220).

2. Le système de détection de défaut (100) selon la revendication 1, dans lequel le processeur de signal débruite le courant statorique à l'aide d'une méthode de formation de faisceaux à variance minimale (MV) avant le calcul.

3. Le système de détection de défaut (100) selon la revendication 1, dans lequel le moniteur du contrôleur (220) affiche le signe de fonctionnement défectueux en réponse à la réception du signal de commande.

4. Le système de détection de défaut (100) selon la revendication 1, dans lequel le signal de commande est indicatif d'un niveau de défaut et d'une position de défaut causés dans le moteur à induction (200).

5. Le système de détection de défaut (100) selon la revendication 1, dans lequel, pour les conditions de fonctionnement variables, un couple électromagnétique est approximé soit par un courant statorique, soit par un courant rotorique du moteur à induction (200) et/ou dans lequel une demi-largeur de bande d'un signal de modulation lié au couple électromagnétique est approximativement réglée à une moitié d'une fréquence de fonctionnement du moteur à induction (200).

6. Le système de détection de défaut (100) selon la revendication 1, dans lequel le vecteur de courant statorique de la condition de fonctionnement stable est initialisé comme une combinaison linéaire d'harmoniques d'une fréquence de fonctionnement du moteur à induction (200) et/ou dans lequel les signatures de défaut sont déterminées en exécutant un programme d'analyse spectrale sur le vecteur d'estimation propre du courant statorique.

7. Le système de détection de défauts (100) selon la revendication 1, dans lequel la résolution comprend en outre
l'initialisation du vecteur de réponse et du vecteur de modulation ; et
la mise à jour, de manière itérative, du vecteur de courant statorique, du vecteur de réponse, et du vecteur de modulation jusqu'à ce que la mise à jour atteigne la convergence.

8. Le système de détection de défauts (100) selon la revendication 1, dans lequel, pour les conditions de fonctionnement variables, un couple électromagnétique est approximé par le courant statorique et un courant rotorique du moteur à induction (200).

9. Un procédé mis en œuvre par ordinateur pour détecter des défauts d'un moteur à induction (200) fonctionnant dans des conditions de fonctionnement variables indicatives de conditions de charge variables (210), de conditions de vitesse variables ou d'une combinaison de celles-ci, comprenant :
la mesure d'un courant statorique du moteur à induction (200) dans les conditions de fonctionnement variables via un capteur de courant (150) connecté à un câble d'alimentation du moteur à induction (200) ;
la formation d'un vecteur de courant statorique par échantillonnage du courant statorique mesuré en utilisant une fréquence d'échantillonnage selon des séquences temporelles ;
la réduction du bruit du vecteur de courant statorique en utilisant une méthode de formation de faisceau à variance minimale (MV) ; **caractérisé en ce qu'**il comprend en outre :
la formulation d'un problème d'optimisation conjoint de déconvolution-démodulation aveugle basé sur le vecteur de courant statorique d'une condition de fonctionnement stable, un vecteur de réponse du moteur à induction (200), un vecteur de modulation de conditions de fonctionnement variables, et un vecteur de bruit pour satisfaire le vecteur de courant statorique mesuré avec un bruit réduit ;
l'estimation du vecteur de courant statorique de la condition de fonctionnement stable, du vecteur de réponse du moteur à induction (200), du vecteur de modulation des conditions de fonctionnement variables, et du vecteur de bruit en résolvant le problème d'optimisation conjoint de déconvolution-démodulation aveugle ;
l'extraction de signatures de défaut à partir d'un vecteur d'estimation de courant statorique propre, dans lequel le vecteur d'estimation de courant statorique propre est généré par utilisation du vecteur de réponse estimé et du vecteur de courant statorique estimé ;
la production d'une commande de contrôle destinée à un contrôleur (220) du moteur à induction (200) si au moins une des signatures de défaut est supérieure à un seuil et commandant le moteur à induction (200) en transmettant la commande de contrôle qui amène le contrôleur (220) à réduire une vitesse de fonctionnement du moteur à induction (200) à un niveau de sécurité, produisant et transmettant sinon une commande normale indicative des fonctionnements normaux du moteur à induction (200) au contrôleur (220).

10. Le procédé de la revendication 9, débruite en outre le courant statorique à l'aide d'une méthode de formation de faisceau à variance minimale (MV) avant le calcul.

11. Le procédé de la revendication 9, dans lequel le moniteur du contrôleur (220) affiche un signe de fonctionnement défectueux sur un affichage du contrôleur (220) en réponse à la réception de la commande de contrôle.

12. Le procédé de la revendication 9, dans lequel la commande de contrôle est indicative d'un niveau de défaut et d'une position de défaut causés dans le moteur à induction (200).

13. Le procédé de la revendication 9, dans lequel pour les conditions de fonctionnement variables, un couple électromagnétique est approximé soit par le courant statorique soit par un courant rotorique du moteur à induction (200) et/ou dans lequel une demi-largeur de bande d'un signal de modulation associé au couple électromagnétique est approximativement réglée à une moitié d'une fréquence de fonctionnement du moteur à induction (200).

14. Le procédé de la revendication 9, dans lequel le vecteur de courant statorique de la condition de fonctionnement stable est initialisé comme une combinaison linéaire d'harmoniques d'une fréquence de fonctionnement du moteur à induction (200) et/ou dans lequel les signatures de défaut sont déterminées en exécutant un programme d'analyse spectrale sur le vecteur d'estimation du courant statorique propre.

15. Procédé selon la revendication 9, dans lequel la résolution comprend
l'initialisation du vecteur de réponse et du vecteur de modulation ; et
la mise à jour, de manière itérative, du vecteur de courant statorique, du vecteur de réponse, et du vecteur de modulation jusqu'à ce que la mise à jour atteigne la convergence et/ou dans lequel, pour les conditions de fonctionnement variables, un couple électromagnétique est approximé par le courant statorique et un courant rotorique du moteur à induction (200).
